# FASCICULE DE BREVET EUROPEEN

(11) **EP 2 715 378 B1**
(45) Date de publication et mention de la délivrance du brevet: **04.07.2018**
(21) Numéro de dépôt: 12729685.3
(22) Date de dépôt: 31.05.2012
(51) Int. Cl.: G01N 27/72, G01N 1/00, G01R 27/26

(54) **PORTE-ECHANTILLON UNIVERSEL POUR DES MESURES DE CARACTERISTIQUES ELECTROMAGNETIQUES D'UN MATERIAU DIELECTRIQUE ET/OU MAGNETIQUE**
UNIVERSELLER PROBENHALTER ZUR MESSUNG DER ELEKTROMAGNETISCHEN EIGENSCHAFTEN EINES DIELEKTRISCHEN UND/ODER MAGNETISCHEN MATERIALS
UNIVERSAL SAMPLE HOLDER FOR MEASURING THE ELECTROMAGNETIC PROPERTIES OF A DIELECTRIC AND/OR MAGNETIC MATERIAL

(30) Priorité: 01.06.2011 FR 1101697
(43) Date de publication de la demande: 09.04.2014
(73) Titulaire: Université d'Aix-Marseille, 13284 Marseille Cedex 07 (FR)
(72) Inventeur: SABOUROUX, Pierre, F-13380 Plan De Cuques (FR)
(74) Mandataire: Novagraaf Technologies
(86) Numéro de dépôt international: PCT/FR2012/051219
(87) Numéro de publication internationale: WO 2012/164229

(56) Documents cités:
- FR-A1- 2 862 758
- SABOUROUX P ET AL: "Epsimu, a tool for dielectric properties measurement of porous media: Application in wet granular materials characterization", PROGRESS IN ELECTROMAGNETICS RESEARCH B, no. 29, 30 mars 2011 (2011-03-30), pages 191-207, XP002667847, ELECTROMAGNETICS ACADEMY USA DOI: 10.2528/PIERB10112209
- BA D ET AL: "EpsiMu, a toolkit for permittivity and permeability measurement in microwave domain at real time of all materials: Applications to solid and semisolid materials", MICROWAVE AND OPTICAL TECHNOLOGY LETTERS, vol. 52, no. 12, décembre 2010 (2010-12), pages 2643-2648, XP002667848, JOHN WILEY AND SONS INC. USA DOI: 10.1002/MOP.25570

## Description

### DOMAINE TECHNIQUE DE L'INVENTION

Le domaine technique de l'invention est celui des mesures de caractéristiques électriques et magnétiques et plus particulièrement celui des mesures de caractéristiques électromagnétiques d'un matériau diélectrique et/ou magnétique. L'invention a donc pour objet un porte-échantillon à relier à un dispositif support d'un porte-échantillon pour des mesures de caractéristiques diélectriques et/ou magnétiques d'un échantillon et un dispositif support associé.

### ETAT DE LA TECHNIQUE ANTERIEURE

La problématique posée par les appareillages de mesure de caractéristiques électromagnétiques d'un matériau diélectrique ou magnétique a déjà suscité plusieurs solutions, notamment celle consistant à la mise en place d'un tel matériau diélectrique ou magnétique dans une cellule de mesure, notamment coaxiale, ladite cellule étant reliée à un analyseur de réseau.

A ce titre, on connaît le brevet d'invention FR 2619223 A1 qui décrit un procédé et un dispositif pour l'estimation des caractéristiques électromagnétiques d'un matériau diélectrique et/ou magnétique. Plus précisément, le document divulgue un dispositif support d'un porte-échantillon pour des mesures de caractéristiques diélectriques et/ou magnétiques d'un échantillon, ledit dispositif support comportant : un premier et un deuxième connecteur adaptés à laisser passer une onde électromagnétique et comprenant des moyens de guidage de l'onde suivant un axe de référence, un premier moyen de connexion situé à une première extrémité du premier connecteur pour le connecter à un moyen pour transmettre une onde électromagnétique et l'appliquer dans le moyen de guidage du premier connecteur, un deuxième moyen de connexion situé à une première extrémité du deuxième connecteur pour recevoir l'onde électromagnétique provenant du moyen de guidage du deuxième connecteur et la faire circuler vers des moyens de traitement, le porte-échantillon étant apte à transmettre tout ou partie de l'onde électromagnétique du premier vers le deuxième connecteur suivant un axe de référence et à être disposé de façon amovible entre eux. En outre, le porte-échantillon renferme une cavité où est logé l'échantillon. Plus précisément, le porte-échantillon comporte un corps externe tubulaire entourant, coaxialement audit axe de référence, ladite cavité où est logé l'échantillon.

Un tel dispositif a notamment pour inconvénient de nécessiter une cavité pour une pièce annulaire d'épaisseur uniforme façonnée dans ledit matériau diélectrique et/ou magnétique. En effet cette pièce annulaire est telle que, lorsqu'elle est disposée dans ladite cavité, ses périphéries extérieure et intérieure sont respectivement en contact de frottement serré avec la surface de la cavité. Par conséquent, un tel dispositif présente des inconvénients de mise en oeuvre lors des mesures effectuées car il nécessite un démontage du porte-échantillon et une étape de mise en place dudit matériau dont résulte une perte de temps et de précision entre deux mesures successives.

D'autre part, si un tel dispositif est apte à mesurer des caractéristiques électromagnétiques de matériaux solides, il présente néanmoins, notamment pour des matériaux de types liquides ou gels, des limitations comme le conditionnement des matériaux dans la cavité, voire l'écoulement du matériau dans le cas où les mesures sont effectuées sur un matériau nécessitant un flux dynamique, ou des mesures continues en temps réel.

En outre, une autre lacune est liée à la difficulté de rendre stérile le dispositif pour des mesures de milieux biologiques.

Par ailleurs, certains systèmes de mesure connus de l'état de l'art pour des mesures de liquides sont soit peu précis, soit utilisables sur une bande de fréquence étroite, ce qui est le cas pour des dispositifs de type capacitifs ou à résonateurs, soit encore limités à un seul paramètre, par exemple la permittivité, ce qui est le cas notamment pour des diapositifs mettant en oeuvre des techniques de sondes coaxiales à effets de bout aussi appelées « open ended coaxial cell ».

SABOUROUX P ET AL: "Epsimu, a tool for dielectric properties measurement of porous média: Application in wet granular materials characterization",PROGRESS IN ELECTROMAGNETICS RESEARCH B, no. 29, 30 mars 2011 (2011-03-30), pages 191-207, XP002667847,ELECTROMAGNETICS ACADEMY USA DOI: 10.2528/ PIERB10112209, BA D ET AL: "EpsiMu, a toolkit for permittivity and permeability measurement in microwave domain at real time of all materials: Applications to solid and semisolid materials",MICROWAVE AND OPTICAL TECHNOLOGY LETTERS, vol. 52, no. 12, décembre 2010 (2010-12), pages 2643-2648, XP002667848,JOHN WILEY AND SONS INC. USA DOI: 10.1002/MOP.25570, et FR 2 862 758 A1 divulguent d'autres appareils.

### EXPOSE DE L'INVENTION

L'invention vise à remédier à certains au moins des inconvénients de l'état de la technique, en particulier aux problèmes de démontage d'une cellule de mesure pour en changer le matériau échantillon diélectrique et/ou magnétique et de conditionnement d'un tel matériau dans le but d'améliorer sa mise en oeuvre.

Dans cet objectif et selon un premier aspect, il est prévu, en complément au document FR 2619223 A1, que la cavité du porte échantillon soit limitée dans une direction par des parois latérales situées de part et d'autre de la cavité, transversalement à l'axe de référence.

Plus précisément, le porte-échantillon, comporte des parois latérales situées transversalement à l'axe de référence, de part et d'autre de la cavité qu'elles limitent ainsi latéralement. En d'autres termes, la cavité est ainsi délimitée à la fois :
- par une paroi du corps externe tubulaire entourant, coaxialement audit axe de référence, ladite cavité ; et
- par des parois disposées transversalement à l'axe de référence de part et d'autre de la cavité la fermant ainsi latéralement.

Un tel porte-échantillon présente de nombreux avantages. Notamment, il présente l'avantage de pouvoir être interchangeable. En effet, les parois latérales disposées sur le porte-échantillon, transversalement à l'axe de référence, et de part et d'autre de la cavité qu'elles ferment ainsi latéralement, garantissent le caractère interchangeable dudit porte-échantillon. Il est alors possible de changer les échantillons sans les détruire car on ne change pas seulement l'échantillon, mais le porte-échantillon qui contient l'échantillon. De plus, il est tout à fait possible de conserver des échantillons sans les détruire dans des porte-échantillons, ceci afin de caractériser lesdits échantillons à plusieurs reprises si besoin est. Un tel porte-échantillon, insérable dans la cellule, est donc interchangeable et réutilisable.

Un autre avantage est de pouvoir confiner dans une cavité du porte-échantillon, différents types de matières, notamment tout ou partie de matière solide, liquide, gazeuse ou granuleuse. En outre, l'utilisation de ce porte-échantillon permet de manipuler sans contact l'échantillon de matière, laquelle est conditionnée dans le porte-échantillon avant les opérations de mesures, ce qui permet ainsi de respecter des conditions notamment de propreté. Notamment, mais ledit porte-échantillon peut subir des prétraitements comme une stérilisation dans le cas où les matériaux à caractériser sont sensibles à la pollution de l'environnement comme par exemple des matériaux biologiques.

Avantageusement, lesdites parois latérales sont amovibles. Cette caractéristique permet notamment de pouvoir changer l'échantillon de matière et/ou d'adapter la taille de la cavité.

Par ailleurs, selon une caractéristique particulière, le porte-échantillon comporte :
- une âme centrale ;
- le corps externe tubulaire entourant l'âme centrale, coaxialement à l'axe de référence ;
- des moyens d'assemblage étanche aptes à relier, de façon étanche au gaz et/ou aux liquides, les parois latérales à l'âme centrale et/ou au corps externe ;
la cavité étant entourée par l'âme centrale, le corps externe et les parois latérales. Dans le cas où l'âme centrale et le corps externe sont sensiblement circulaires, la cavité est sensiblement en forme disque dont l'épaisseur est la distance entre les parois latérales.

Ces caractéristiques permettent au porte-échantillon de pouvoir disposer d'une cavité dans laquelle peut être conditionné un matériau en respectant les conditions d'étanchéité, de propreté et de stérilité éventuelle, ce matériau pouvant être aussi bien solide que liquide. Par conséquent, il est possible de manipuler un porte-échantillon en conservant un conditionnement optimal du matériau échantillon dans un environnement stérile.

Selon une caractéristique spécifique, le porte-échantillon comporte :
- des moyens d'entrée et de sortie de l'échantillon permettant un flux de matériau dans la cavité, dans le cas où l'échantillon est en matériau coulant. Est entendu par le vocable « matériau coulant », un matériau sous forme liquide ou visqueuse, par exemples des fluides ou des gels. De tels moyens permettent des mesures de caractéristiques électromagnétiques d'une matière diélectrique et/ou magnétique présentant et/ou nécessitant un flux dynamique pour pouvoir effectuer des mesures continues en temps réel tout en garantissant l'interchangeabilité du porte-échantillon ;
   et/ou
- des moyens de mesures de caractéristiques intrinsèques de l'échantillon et/ou des moyens aptes à faire varier ces caractéristiques intrinsèques dans le porte-échantillon.

Il est entendu par le vocable « caractéristiques intrinsèques » des matériaux, des grandeurs physiques mesurables de façon objective, ce sont toutes les propriétés mécaniques, thermiques, électriques, magnétiques, optiques.

Par exemple, dans le cas où la caractéristique intrinsèque considérée est la température, un moyen de mesure de la température de l'échantillon peut être un thermomètre électrique relié à une sonde de mesure comprenant au moins une résistance, et un moyen apte à faire varier la température peut être une résistance.

Avantageusement, les parois latérales du porte-échantillon sont en matériau(x) diélectrique(s), notamment pour être transparent(s) à la propagation des ondes électromagnétiques, et/ou l'âme centrale et le corps externe sont en matériau(x) électriquement conducteur(s).

Selon une autre caractéristique particulière, l'âme centrale présente suivant l'axe de référence une première et une deuxième extrémités adaptées à engager par encastrement les premier et deuxième connecteurs.

De façon avantageuse :
- l'âme centrale présente une partie centrale et, latéralement, un arbre s'étendant suivant l'axe de référence de part et d'autre de la partie centrale, les parois latérales en forme de disque étant respectivement reçues sur l'arbre, où elles sont serrées par des premiers moyens de serrage appartenant aux moyens d'assemblage étanche.
   et/ou
- le corps externe présente latéralement des évidements où les parois latérales sont reçues et serrées par des deuxièmes moyens de serrage appartenant aux moyens d'assemblage étanche.

Par ailleurs, l'invention concerne également un dispositif support d'un porte-échantillon pour des mesures de caractéristiques diélectriques et/ou magnétiques d'un échantillon, ledit dispositif support comportant :
- un premier et un deuxième connecteurs adaptés à laisser passer une onde électromagnétique et comprenant des moyens de guidage de l'onde suivant un axe de référence ;
- un premier moyen de connexion situé à une première extrémité du premier connecteur pour le connecter à un moyen pour transmettre une onde électromagnétique et l'appliquer dans le moyen de guidage du premier connecteur ;
- un deuxième moyen de connexion situé à une première extrémité du deuxième connecteur pour recevoir l'onde électromagnétique provenant du moyen de guidage du deuxième connecteur et la faire circuler vers des moyens de traitement ;

Selon un aspect particulier, ledit dispositif support comporte un porte-échantillon, lequel comporte tout ou partie des caractéristiques énoncées précédemment et, est disposé de façon amovible entre les premier et deuxième connecteurs.

Un tel dispositif support offre de nombreux avantages. En effet, en plus des avantages liés au porte-échantillon déjà développés précédemment, un tel dispositif support dudit porte-échantillon pour des mesures de caractéristiques diélectriques permet d'effectuer des mesures rapides. En effet, de part la facilité d'interchangeabilité dudit porte échantillon, un tel support permet, au moyen d'une seule mesure fréquentielle, d'obtenir des résultats en temps quasi-réel.

Par ailleurs, selon une autre caractéristique, les premier et deuxième connecteurs présentent chacun des épaulements où est logé et positionné le porte-échantillon.

Avantageusement, le dispositif support comporte des troisièmes moyens de serrage du premier connecteur sur le deuxième connecteur, à l'écart du porte-échantillon, les troisièmes moyens de serrages étant de cette manière fixés au premier et au deuxième connecteurs

### BREVE DESCRIPTION DES FIGURES

D'autres caractéristiques et avantages de l'invention ressortiront à la lecture de la description qui suit, en référence aux figures annexées, qui illustrent :
- les figures 1 et 2, deux schémas d'un porte-échantillon selon un mode de réalisation, représentant respectivement le porte-échantillon assemblé et dans une vue éclatée ;
- la figure 3, un schéma d'un dispositif support selon un mode de réalisation ;
- les figures 4 et 5, deux schémas d'un porte-échantillon selon deux autres modes de réalisations différents ;
- la figure 6, un schéma de principe d'un dispositif de mesure comportant un dispositif support et un porte-échantillon selon un mode de réalisation ;

Pour plus de clarté, les éléments identiques ou similaires sont repérés par des signes de référence identiques sur l'ensemble des figures.

### DESCRIPTION DETAILLEE D'UN MODE DE REALISATION

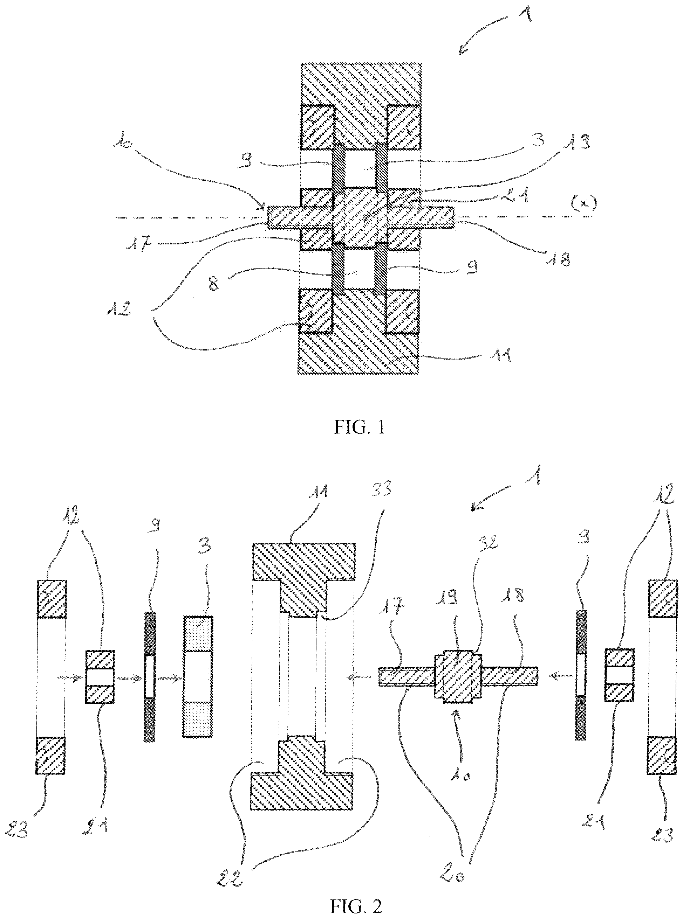

Les figures 1 et 2 montrent deux schémas d'un porte-échantillon selon un mode de réalisation, représentant respectivement le porte-échantillon assemblé et le porte-échantillon dans une vue éclatée.

Est représenté plus particulièrement un porte-échantillon 1, renfermant une cavité 8 où est logé un échantillon 3, ladite cavité 8 étant fermée par des parois latérales 9 situées de part et d'autre de la cavité 8, transversalement à un axe de référence (x), les parois latérales étant en matériau(x) diélectrique(s).

Il est à noter que sur ces figures et dans ce mode de réalisation, l'axe de référence (x) constitue un axe de révolution des pièces représentées.

Plus précisément, le porte-échantillon 1 comporte :
- une âme centrale 10 en matériau électriquement conducteur ;
- un corps externe 11 tubulaire entourant l'âme centrale 10, coaxialement à l'axe de référence (x), le corps externe 11 étant en matériau électriquement conducteur ;
- des moyens d'assemblage matériau électriquement conducteur et étanche 12 aptes à relier, de façon étanche au gaz et/ou aux liquides, les parois latérales 9 à l'âme centrale 10 et/ou au corps externe 11 ;
la cavité 8 étant entourée par l'âme centrale 10, le corps externe 11 et les parois latérales 9.

Dans des modes de réalisations différents, la cavité 8 peut également être entourée par des joints supplémentaires aptes à assurer une étanchéité supplémentaire. Par ailleurs, ladite cavité 8 présente dans cet exemple une section circulaire mais peut être de formes différentes.

Les parois utilisées dans ce mode de réalisation sont en matériau diélectrique, et peuvent être plus particulièrement en matériau diélectrique comme par exemple du Téflon ou du Polychlorure de Vinyle (PVC) suivant les besoins et les compatibilités chimiques avec le matériau sous test placé dans la cavité 8.

Par ailleurs, l'âme centrale 10 présente, suivant l'axe de référence (x), une première et une deuxième extrémités 17, 18 adaptées à engager par encastrement et/ou vissage les premier et deuxième connecteurs 4, 5. En effet, de façon plus précise, l'âme centrale 10 présente une partie centrale 19 et, latéralement, un arbre 20 s'étendant suivant l'axe de référence (x) de part et d'autre de la partie centrale 19, les parois latérales 9 en forme de disque étant respectivement reçues sur l'arbre 20, où elles sont serrées par des premiers moyens de serrage 21 appartenant aux moyens d'assemblage étanche 12. Dans ce mode de réalisation, les première et deuxième extrémités 17, 18 sont les extrémités de l'arbre 20 faisant saillies latéralement à la partie centrale. Ainsi, l'arbre 20 présente ici deux fonctions : l'une étant de recevoir les premiers moyens de serrage 21, la seconde étant de s'engager par encastrement dans les premier et deuxième connecteurs 4, 5.

De plus, le corps externe 11 présente latéralement des évidements 22 où les parois latérales 9 sont reçues et serrées par des deuxièmes moyens de serrage 23 appartenant aux moyens d'assemblage étanche 12.

Les parois latérales 9, chacune en forme de disque, présentent un diamètre intérieur et un diamètre extérieur :
- le diamètre intérieur des parois latérales 9 étant légèrement inférieur au diamètre extérieur de la partie centrale 19 de l'âme centrale 10 ; et
- le diamètre extérieur des parois latérales 9 étant légèrement supérieur au diamètre intérieur du corps externe 11 ;
de sorte que les parois latérales 9 puissent fermer la cavité ainsi délimitée par l'âme centrale 10, le corps externe 11 et les parois latérales 9. Plus précisément, la partie centrale 19 de l'âme centrale 10 et corps externe 11 comportent respectivement des épaulements latéraux 32, 33 recevant en butée les parois latérales 9.

Les premiers moyens de serrage 21 présentent un diamètre interne apte à venir se fixer par vissage de part et d'autre de l'âme centrale 10 sur l'arbre 20 s'étendant suivant l'axe de référence (x) et un diamètre extérieur sensiblement égal au diamètre extérieur de la partie centrale 19 de l'âme centrale 10 assurant la fixation des parois latérales 9 dans les épaulements latéraux 32.

De manière sensiblement équivalente, les deuxièmes moyens de serrage 23 présentent d'une part, un diamètre extérieur apte à venir se fixer par vissage de part et d'autre de l'âme centrale 10 dans les évidements 22 du corps externe 11 s'étendant suivant l'axe de référence (x) et, d'autre part, un diamètre intérieur sensiblement égal au diamètre intérieur du corps externe 11 assurant la fixation des parois latérales 9 dans les épaulements latéraux 33.

Dans cette configuration, les parois latérales 9 sont donc amovibles par rapport au corps externe 11 et à l'âme centrale 10.

Un tel porte-échantillon 1 permet d'étudier les caractéristiques de matériaux de natures très diverses telles que des matériaux solides, granulaires, pulvérulents, liquides ou gels.

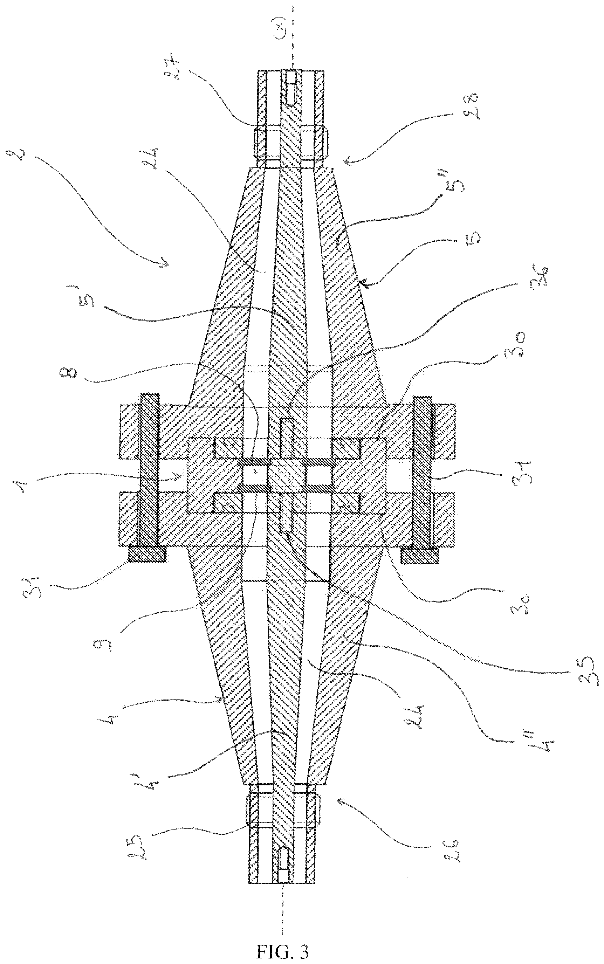

La figure 3 montre un schéma d'un dispositif support selon un mode de réalisation, comprenant un porte-échantillon 1 selon le mode de réalisation illustré figures 1 et 2.

Ainsi, est représenté un dispositif support 2 comportant :
- un premier et un deuxième connecteurs 4, 5 adaptés à laisser passer une onde électromagnétique et comprenant des moyens de guidage 24 de l'onde suivant l'axe de référence (x) ;
- un premier moyen de connexion 25 situé à une première extrémité 26 du premier connecteur 4 pour le connecter à un moyen 6 pour transmettre une onde électromagnétique et l'appliquer dans le moyen de guidage 24 du premier connecteur 4 ;
- un deuxième moyen de connexion 27 situé à une première extrémité 28 du deuxième connecteur 5 pour recevoir l'onde électromagnétique provenant du moyen de guidage 24 du deuxième connecteur 5 et la faire circuler vers des moyens de traitement 29.

En outre, les premier et deuxième connecteurs 4, 5 comportent :
- une première et une deuxième âmes 4', 5' en une matière électriquement conductrice ;
- un premier et un deuxième corps tubulaires 4", 5", en une matière électriquement conductrice, entourant respectivement les première et deuxième âmes 4', 5' de sorte que les première et deuxième âmes 4', 5' et lesdits connecteurs 4, 5 forment une structure coaxiale selon l'axe de référence (x) ;

Ainsi, le moyen de guidage 24 de l'onde électromagnétique est la structure coaxiale elle-même, ladite onde électromagnétique pouvant circuler dans l'espace défini respectivement entre les première et deuxième âmes 4', 5' et entre les premier et deuxième corps tubulaires 4", 5".

Par ailleurs, les première et deuxième extrémités 17, 18 de l'arbre 20 de l'âme centrale 10 porte-échantillon sont engagées par encastrement respectivement dans les premier et deuxième connecteurs 4, 5, et plus précisément dans des première et deuxième cavités 35, 36 des première et deuxième âmes 4', 5' respectives. Cette configuration permet de centrer précisément le porte-échantillon 1 dans le dispositif support 2. En d'autres termes, la cavité 8 du porte-échantillon 1 est centrée avec le moyen de guidage 24 et, a fortiori, avec les parois latérales 9 afin que l'onde électromagnétique soit apte à circuler du premier connecteur 4 vers le deuxième connecteur 5 en traversant la cavité 8, laquelle comportant l'échantillon 3 de matière devant être caractérisé.

De plus, dans ce mode de réalisation, les premier et deuxième connecteurs 4, 5 présentent chacun des épaulements 30 aptes à y loger le porte-échantillon 1, ces dits épaulements 30 étant de ce fait aptes à assurer également un bon centrage du porte-échantillon 1 entre les premier et deuxième connecteurs 4, 5.

Il est illustré également des troisièmes moyens de serrage 31 du premier connecteur 4 sur le deuxième connecteur 5, à l'écart du porte-échantillon 1. De cette manière, les troisièmes moyens de serrages sont fixés au premier et au deuxième connecteurs 4, 5. En particulier dans ce mode de réalisation, les premier et deuxième corps tubulaires 4", 5" présentent une surface extérieure sensiblement conique dont la base est élargie afin de pouvoir recevoir lesdits troisièmes moyens de serrage 31.

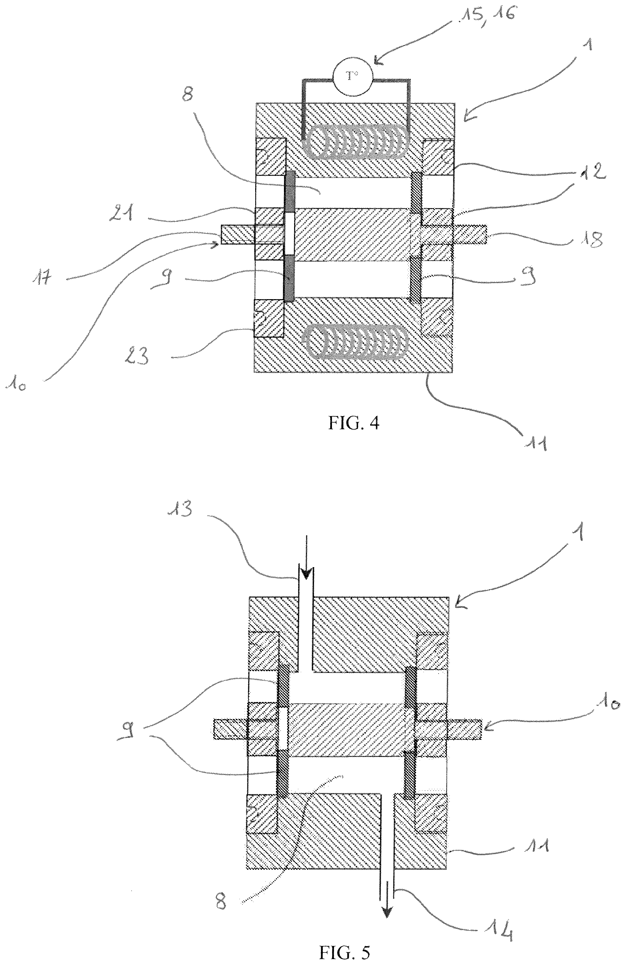

Les figures 4 et 5 montrent deux schémas d'un porte-échantillon selon deux autres modes de réalisations différents.

En effet, est représenté figure 4, un porte-échantillon comportant, en plus de celui illustré figure 1 et 2, des moyens de mesure 15 de température, la température étant une caractéristiques intrinsèque de l'échantillon 3, et des moyens 16 aptes à faire varier cette température dans le porte-échantillon 1, ces moyens pouvant être une résistance commandée électriquement et une sonde de température reliée à un thermomètre.

Par ailleurs, est représenté figure 5, un porte-échantillon comportant, en plus de celui illustré figure 1 et 2, des moyens d'entrée 13 et de sortie 14 de l'échantillon 3 permettant un flux de matériau dans la cavité 8. Ce mode de réalisation est optimal pour étudier les caractéristiques diélectriques et/ou magnétiques d'un échantillon en matériau coulant.

Est entendu par le vocable « matériau coulant », un matériau sous forme liquide ou visqueuse, par exemples des fluides ou des gels.

Cette configuration permet notamment d'étudier un tel matériau présentant un flux dynamique, le sens de circulation du fluide étant ici matérialisé à titre indicatif par des flèches.

Ce mode de réalisation est ainsi particulièrement avantageux pour effectuer des mesures continues dans le temps et de visualiser des variations en temps réel de certains caractéristiques comme le taux de polluant dans un milieu aqueux ou encore des concentrations de liquides miscibles dans l'eau.

On aura noté que dans tous les cas, la cavité 8 est fermée, ce qui permet au porte-échantillon d'être interchangeable, indépendamment de son dispositif support 2, et en particulier des premier et deuxième connecteurs 4, 5. Dans la variante de la fig.5, la cavité 8 est effectivement fermée, malgré les moyens d'entrée 13 et de sortie 14 de l'échantillon, dans la mesure où les parois 9 et le corps 11 le limitent pleinement sur toute sa périphérie hors les entrée 13 et sortie 14 qui ne constituent que des passages ponctuels fermables et ouvrables à volonté par un bouchon et permettant donc au porte-échantillon de conserver son interchangeabilité.

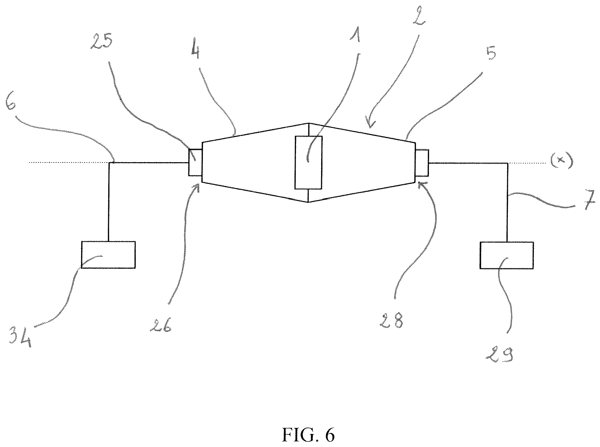

La figure 6 montre un schéma de principe général d'un dispositif de mesure comportant un dispositif support et un porte-échantillon selon un mode de réalisation.

Est représenté en particulier sur cette figure un schéma général d'un dispositif de mesure de caractéristiques électromagnétiques d'un matériau diélectrique ou magnétique comportant porte-échantillon 1 à relié à un dispositif support 2 du porte-échantillon dont le mode de réalisation est détaillé figure 3, ledit dispositif support 2 étant connecté :
- à la première extrémité 26 du premier connecteur 4 à un moyen 6 pour transmettre une onde électromagnétique à partir d'un émetteur 34 et l'appliquer dans le moyen de guidage 24 du premier connecteur 4,
- à la première extrémité 28 du deuxième connecteur 5 pour recevoir l'onde électromagnétique provenant du moyen de guidage 24 du deuxième connecteur 5 et la faire circuler vers des moyens de traitement 29 par l'intermédiaire d'un moyen 7 pour faire circuler l'onde électromagnétique après son passage dans le dispositif support 2 et le porte-échantillon 1

Les moyens de traitement 29 dans le mode de réalisation ici décrit est un analyseur de réseau vectoriel. De tels moyens de traitement ne sont pas nécessairement un analyseur de réseau vectoriel mais peuvent être plus généralement tout autre système de génération, de réception et d'analyse d'ondes électromagnétiques similaire pour arriver au même résultat.

Il est précisé qu'un tel porte-échantillon offre l'avantage d'être plurifonctionnel et de pouvoir être utilisé dans des domaines d'applications industrielles très divers et variés dont on peut citer particulièrement mais non exclusivement les suivants :
- domaine d'application sur des solides : tous solides de type diélectrique (comme des matières plastiques) utilisés dans la constitution de tous les produits dédiés à la transmission et au traitement d'informations ;
- domaines d'applications sur des liquides :
   ▪ un premier domaine concerne la caractérisation directe de matériaux liquides ou dérivés comme des gels, ou des liquides visqueux (liquides et gels inertes, liquides biologiques utilisés pour des milieux de cultures ou matériaux vivants comme des produits sanguins) ;
   ▪ un deuxième domaine concerne les applications indirectes comme la détection et le suivi de présence de produits polluants. Cette solution de détection pouvant être implantée directement in-situ c'est-à-dire dans les canalisations ou dans des dérivations de flux. Une autre application indirecte concerne les produits biologiques ou vivants comme le suivi de la concentration de certains composants de liquides comme des dérivés sanguins ;
- Un autre domaine d'application concerne la caractérisation de matériaux de types liquides chargés, liquides magnétiques, ou bien cristaux liquides. Ce sont tous ces liquides, de matières inertes qui ont des applications très grand public et pour lesquels la connaissance des caractéristiques électromagnétiques est fondamentale pour bien comprendre les interactions entre ces matériaux et les circuits électroniques environnants.

De nombreuses modifications peuvent être apportées au mode de réalisation décrit précédemment sans sortir du cadre de l'invention.

Ainsi, les moyens d'assemblage étanche et/ou les moyens de serrages peuvent différer, de la même manière que les moyens de centrage du porte-échantillon entre les premier et deuxième connecteurs peuvent différer. Par exemple le porte-échantillon peut comporter des cavités dans lesquelles viennent s'engager les extrémités des première et deuxième âmes. Il est également envisageable de disposer des vis réparties de manière sensiblement homogène latéralement aux deuxièmes moyens de serrage de sorte que les vis traversent l'épaisseur desdits deuxièmes moyens de serrage et finissent leurs courses dans des pas de vis disposés en regard latéralement sur le corps extérieur.

Une autre évolution ou modification possible pourrait se situer au niveau du troisième moyen de serrage 31, on peut envisager un système par verrouillage par levier ou clip ce qui permettrait d'optimiser les opérations d'ouverture et de fermeture des éléments support pour changer le porte-échantillon.

Par ailleurs il est également envisageable d'ajouter des moyens d'étanchéité ou des moyens permettant de conditionner le matériau sous une certaine forme et permettant ainsi, par exemple, de conditionner un échantillon de matière dans des conditions de pression déterminées. Dans ce cas les moyens de conditionnement additionnels doivent permettent d'assurer une étanchéité de la cavité tout en supportant une certaine pression.

De plus, dans le cas présent, le dispositif support présente une structure de guidage d'onde électromagnétique coaxiale. Cependant le porte-échantillon ici décrit peut tout aussi bien être utilisé avec une structure de propagation circulaire ou rectangulaire. Dans le premier cas le porte-échantillon est légèrement modifié en supprimant l'âme centrale et les perçages centraux des cloisons latérales. Dans le second cas le porte-échantillon est modifié en supprimant l'âme centrale et les perçages centraux des cloisons latérales et en changeant la forme de la section droite, cette section droite étant alors rectangulaire les cloisons latérales étant des alors des parallélépipèdes fins et la section droite du corps externe étant aussi rectangulaire. Dans ces conditions les formes générales des connecteurs doivent être adaptées à la forme du porte-échantillon.

Par ailleurs, la structure tubulaire de guidage de l'onde électromagnétique peut aussi être de dimension constante ou variable, par exemple cylindrique ou conique pour un guide d'onde de section circulaire ou bien pyramidale tronquée pour un guide d'onde de section rectangulaire

Enfin, les épaulements des premier et deuxième connecteurs aptes à y loger et positionner le porte-échantillon peuvent être de nature différente de telle sorte qu'ils soient aptes à centrer mécaniquement le porte-échantillon par rapport au dispositif support.

## Revendications

1. Porte-échantillon (1) à relier à un dispositif support (2) d'un porte-échantillon pour des mesures de caractéristiques diélectriques et/ou magnétiques d'un échantillon (3), ledit dispositif support (2) comportant : un premier et un deuxième connecteurs (4, 5) adaptés à laisser passer une onde électromagnétique, et à être respectivement connectés à un moyen (6) pour transmettre l'onde électromagnétique et à un moyen (7) pour faire circuler l'onde électromagnétique après son passage dans le dispositif support (2) et le porte-échantillon (1), lequel est apte à transmettre tout ou partie de l'onde électromagnétique du premier (4) vers le deuxième (5) connecteurs suivant un axe de référence (x) et à être disposé de façon amovible entre eux, le porte-échantillon (1) comportant un corps externe (11) tubulaire entourant coaxialement audit axe de référence (x) une cavité (8) où est logé l'échantillon (3), et comportant aussi des parois latérales (9) situées transversalement à l'axe de référence (x), de part et d'autre de la cavité (8) qu'elles ferment ainsi latéralement.

2. Porte-échantillon (1) selon la revendication 1, **caractérisé en ce que** les parois latérales (9) sont amovibles.

3. Porte-échantillon (1) selon la revendication 1 ou 2, **caractérisé en ce qu'**il comporte :
- une âme centrale (10), le corps externe (11) tubulaire entourant l'âme centrale (10), coaxialement à l'axe de référence (x) ;
- des moyens d'assemblage étanche (12) aptes à relier, de façon étanche au gaz et/ou aux liquides, les parois latérales (9) à l'âme centrale (10) et/ou au corps externe ;
la cavité (8) étant entourée par l'âme centrale (10), le corps externe (11) et les parois latérales (9).

4. Porte-échantillon (1) selon l'une des revendications précédentes, **caractérisé en ce que** l'échantillon (3) est en matériau coulant, et **en ce que** le porte-échantillon (1) comporte des moyens d'entrée (13) et de sortie (14) de l'échantillon (3) permettant un flux de matériau dans la cavité (8).

5. Porte-échantillon (1) selon l'une des revendications précédentes, **caractérisé en ce qu'**il comporte des moyens de mesure (15) de caractéristiques intrinsèques de l'échantillon (3) et/ou des moyens (16) aptes à faire varier ces caractéristiques intrinsèques dans le porte-échantillon (1).

6. Porte-échantillon (1) selon la revendication 3 ou la revendication 3 et l'une des revendications 4 ou 5, **caractérisé en ce que** les parois latérales (9) du porte-échantillon (1) sont en matériau(x) diélectrique(s) et/ou l'âme centrale (10) et le corps externe (11) sont en matériau(x) électriquement conducteur(s).

7. Porte-échantillon (1) selon la revendication 3 ou la revendication 3 et l'une des revendications 4 à 6, **caractérisé en ce que** l'âme centrale (10) présente suivant l'axe de référence (x) une première et une deuxième extrémités (17, 18) adaptées à engager par encastrement les premier et deuxième connecteurs (4, 5).

8. Porte-échantillon (1) selon la revendication 3 ou la revendication 3 et l'une des revendications 4 à 7, **caractérisé en ce que** l'âme centrale (10) présente une partie centrale (19) et, latéralement, un arbre (20) s'étendant suivant l'axe de référence (x) de part et d'autre de la partie centrale (19), les parois latérales (9) en forme de disque étant respectivement reçues sur l'arbre (20), où elles sont serrées par des premiers moyens de serrage (21) appartenant aux moyens d'assemblage étanche (12).

9. Porte-échantillon (1) selon la revendication 3 ou la revendication 3 et l'une des revendications 4 à 8, **caractérisé en ce que** le corps externe (11) présente latéralement des évidements (22) où les parois latérales (9) sont reçues et serrées par des deuxièmes moyens de serrage (23) appartenant aux moyens d'assemblage étanche (12).

10. Dispositif support (2) d'un porte-échantillon pour des mesures de caractéristiques diélectriques et/ou magnétiques d'un échantillon (3), ledit dispositif support comportant :
- un premier et un deuxième connecteurs (4, 5) adaptés à laisser passer une onde électromagnétique et comprenant des moyens de guidage (24) de l'onde suivant un axe de référence (x) ;
- un premier moyen de connexion (25) situé à une première extrémité (26) du premier connecteur (4) pour le connecter à un moyen (6) pour transmettre une onde électromagnétique et l'appliquer dans le moyen de guidage (24) du premier connecteur (4) ;
- un deuxième moyen de connexion (27) situé à une première extrémité (28) du deuxième connecteur (5) pour recevoir l'onde électromagnétique provenant du moyen de guidage (24) du deuxième connecteur (5) et la faire circuler vers des moyens de traitement (29) ;
le dispositif support (2) étant **caractérisé en ce qu'**il comporte un porte-échantillon (1) selon l'une des revendications 1 à 9 disposé de façon amovible entre les premier et deuxième connecteurs (4, 5).

11. Dispositif support (2) selon la revendication 10, **caractérisé en ce que** les premier et deuxième connecteurs (4, 5) présentent chacun des épaulements (30) où est logé et positionné le porte-échantillon (1).

12. Dispositif support (2) selon l'une des revendications 10 ou 11, **caractérisé en ce qu'**il comporte des troisièmes moyens de serrage (31) du premier connecteur (4) sur le deuxième connecteur (5), à l'écart du porte-échantillon (1).

## Patentansprüche

1. Probenhalter (1) zum Anschließen an eine Tragvorrichtung (2) eines Probenhalters für Messungen von dielektrischen und/oder magnetischen Eigenschaften einer Probe (3), wobei die Tragvorrichtung (2) umfasst: ein erstes und ein zweites Verbindungsstück (4, 5), die dazu ausgebildet sind, eine elektromagnetische Welle durchtreten zu lassen, und dazu, jeweils mit einem Mittel (6) zum Übertragen der elektromagnetischen Welle und mit einem Mittel (7) zum Umlaufenlassen der elektromagnetischen Welle nach ihrem Durchtritt in die Tragvorrichtung (2) und den Probenhalter (1) verbunden zu werden, welcher in der Lage ist, die gesamte oder einen Teil der elektromagnetischen Welle vom ersten (4) zum zweiten (5) Verbindungsstück hin entlang einer Referenzachse (x) zu übertragen und in herausnehmbarer Weise zwischen denselben angeordnet zu werden, wobei der Probenhalter (1) einen rohrförmigen Außenkörper (11) umfasst, der koaxial zur Referenzachse (x) einen Hohlraum (8) umgibt, in welchem die Probe (3) untergebracht ist, und ebenfalls Seitenwände (9) umfasst, die quer zur Referenzachse (x) beidseits des Hohlraums (8) liegen, den sie so seitlich schließen.

2. Probenhalter (1) nach Anspruch 1, **dadurch gekennzeichnet, dass** die Seitenwände (9) herausnehmbar sind.

3. Probenhalter (1) nach Anspruch 1 oder 2, **dadurch gekennzeichnet, dass** er umfasst:
- eine zentrale Seele (10), wobei der rohrförmige Außenkörper (11) die zentrale Seele (10) koaxial zur Referenzachse (x) umgibt;
- Mittel zum dichten Zusammenfügen (12), die in der Lage sind, die Seitenwände (9) in gas- und/oder flüssigkeitsdichter Weise an die zentrale Seele (10) und/oder an den Außenkörper anzuschließen;
wobei der Hohlraum (8) von der zentralen Seele (10), dem Außenkörper (11) und den Seitenwänden (9) umgeben ist.

4. Probenhalter (1) nach einem der vorstehenden Ansprüche, **dadurch gekennzeichnet, dass** die Probe (3) aus fließfähigem Material ist, und dadurch, dass der Probenhalter (1) Mittel zum Einlassen (13) und zum Auslassen (14) der Probe (3) umfasst, die einen Materialstrom im Hohlraum (8) ermöglichen.

5. Probenhalter (1) nach einem der vorstehenden Ansprüche, **dadurch gekennzeichnet, dass** er Mittel zum Messen (15) der intrinsischen Eigenschaften der Probe (3) und/oder Mittel (16) umfasst, die in der Lage sind, diese intrinsischen Eigenschaften im Probenhalter (1) zu variieren.

6. Probenhalter (1) nach Anspruch 3 oder Anspruch 3 und einem der Ansprüche 4 oder 5, **dadurch gekennzeichnet, dass** die Seitenwände (9) des Probenhalters (1) aus dielektrischem/n Material(ien) sind und/oder die zentrale Seele (10) und der Außenkörper (11) aus elektrisch leitendem/n Material(ien) sind.

7. Probenhalter (1) nach Anspruch 3 oder Anspruch 3 und einem der Ansprüche 4 bis 6, **dadurch gekennzeichnet, dass** die zentrale Seele (10) entlang der Referenzachse (x) ein erstes und ein zweites Ende (17, 18) aufweist, die in der Lage sind, durch Einspannen mit dem ersten und zweiten Verbindungsstück (4, 5) einzugreifen.

8. Probenhalter (1) nach Anspruch 3 oder Anspruch 3 und einem der Ansprüche 4 bis 7, **dadurch gekennzeichnet, dass** die zentrale Seele (10) einen zentralen Abschnitt (19) und seitlich eine Welle (20) aufweist, welche sich beidseits des zentralen Abschnitts (19) entlang der Referenzachse (x) erstreckt, wobei die Seitenwände (9) in Scheibenform jeweils auf der Welle (20) aufgenommen werden, wo sie von ersten Spannmitteln (21), die zu den Mitteln zum dichten Zusammenfügen (12) gehören, verspannt werden.

9. Probenhalter (1) nach Anspruch 3 oder Anspruch 3 und einem der Ansprüche 4 bis 8, **dadurch gekennzeichnet, dass** der Außenkörper (11) seitlich Ausnehmungen (22) aufweist, an denen die Seitenwände (9) aufgenommen und von zweiten Spannmitteln (23), die zu den Mitteln zum dichten Zusammenfügen (12) gehören, verspannt werden.

10. Tragvorrichtung (2) eines Probenhalters für Messungen von dielektrischen und/oder magnetischen Eigenschaften einer Probe (3), wobei die Tragvorrichtung umfasst:
- ein erstes und ein zweites Verbindungsstück (4, 5), die in der Lage sind, eine elektromagnetische Welle durchtreten zu lassen, und Mittel zum Leiten (24) der Welle entlang einer Referenzachse (x) umfassen;
- ein erstes Verbindungsmittel (25), das an einem ersten Ende (26) des ersten Verbindungsstücks (4) liegt, um dasselbe mit einem Mittel (6) zum Übertragen einer elektromagnetischen Welle zu verbinden und dieselbe im Leitmittel (24) des ersten Verbindungstücks (4) anzulegen;
- ein zweites Verbindungsmittel (27), das an einem ersten Ende (28) des zweiten Verbindungsstücks (5) liegt, um die aus dem Leitmittel (24) des zweiten Verbindungsstücks (5) kommende elektromagnetische Welle zu empfangen und dieselbe zu Verarbeitungsmitteln (29) hin umlaufen zu lassen;
wobei die Tragvorrichtung (2) **dadurch gekennzeichnet ist, dass** sie einen Probenhalter (1) nach einem der Ansprüche 1 bis 9 umfasst, der in herausnehmbarer Weise zwischen dem ersten und zweiten Verbindungsstück (4, 5) angeordnet ist.

11. Tragvorrichtung (2) nach Anspruch 10, **dadurch gekennzeichnet, dass** das erste und zweite Verbindungsstück (4, 5) jedes Schultern (30) aufweisen, an denen der Probenhalter (1) untergebracht und positioniert wird.

12. Tragvorrichtung (2) nach einem der Ansprüche 10 oder 11, **dadurch gekennzeichnet, dass** sie dritte Mittel zum Verspannen (31) des ersten Verbindungsstücks (4) am zweiten Verbindungsstück (5) in Abstand vom Probenhalter (1) umfasst.

## Claims

1. A sample holder (1) to be linked to a support device (2) of a sample holder for measurements of dielectric and/or magnetic characteristics of a sample (3), said support device (2) comprising: a first connector and a second connector (4, 5) suitable for allowing an electromagnetic wave to pass therethrough, and for being respectively connected to a means (6) for transmitting the electromagnetic wave and to a means (7) for circulating the electromagnetic wave after its passage through the support device (2) and the sample holder (1), which is able to transmit all or part of the electromagnetic wave from the first (4) to the second (5) connector along a reference axis (x) and to be disposed therebetween in a mutually removable manner, the sample holder (1) comprising a tubular external body (11) surrounding coaxially with said reference axis (x) a cavity (8) where the sample (3) is housed, and comprising lateral walls (9) situated transversely to the reference axis (x), on either side of the cavity (8) that they thus close laterally.

2. The sample holder (1) as claimed in claim 1, **characterized in that** the lateral walls (9) are removable.

3. The sample holder (1) as claimed in claim 1 or 2, **characterized in that** it comprises:
- a central core (10), the tubular external body (11) surrounding the central core (10), coaxially with the reference axis (x);
- means of leaktight assembly (12) able to link, in a gas-tight and/or liquid-tight manner, the lateral walls (9) to the central core (10) and/or to the external body;
the cavity (8) being surrounded by the central core (10), the external body (11) and the lateral walls (9).

4. The sample holder (1) as claimed in one of the preceding claims, **characterized in that** the sample (3) is made of pouring material, and **in that** the sample holder (1) comprises means of entry (13) and of exit (14) of the sample (3) allowing a flow of material in the cavity (8).

5. The sample holder (1) as claimed in one of the preceding claims, **characterized in that** it comprises means of measurement (15) of intrinsic characteristics of the sample (3) and/or means (16) able to vary these intrinsic characteristics in the sample holder (1).

6. The sample holder (1) as claimed in claim 3 or claim 3 and one of claims 4 or 5, **characterized in that** the lateral walls (9) of the sample holder (1) are made of dielectric material(s) and/or the central core (10) and the external body (11) are made of electrically conducting material(s).

7. The sample holder (1) as claimed in claim 3 or claim 3 and one of claims 4 to 6, **characterized in that** the central core (10) exhibits along the reference axis (x) a first end and a second end (17, 18) suitable for engaging by fastening the first and second connectors (4, 5) .

8. The sample holder (1) as claimed in claim 3 or claim 3 and one of claims 4 to 7, **characterized in that** the central core (10) exhibits a central part (19) and, laterally, a shaft (20) extending along the reference axis (x) on either side of the central part (19), the disk-shaped lateral walls (9) being respectively received on the shaft (20), where they are clamped by first clamping means (21) belonging to the means of leaktight assembly (12).

9. The sample holder (1) as claimed in claim 3 or claim 3 and one of claims 4 to 8, **characterized in that** laterally the external body (11) exhibits recesses (22) where the lateral walls (9) are received and clamped by second clamping means (23) belonging to the means of leaktight assembly (12).

10. A support device (2) of a sample holder for measurements of dielectric and/or magnetic characteristics of a sample (3), said support device comprising:
- a first connector and a second connector (4, 5) suitable for allowing an electromagnetic wave to pass therethrough and comprising means of guidance (24) of the wave along a reference axis (x);
- a first connection means (25) situated at a first end (26) of the first connector (4) for connecting it to a means (6) for transmitting an electromagnetic wave and applying it in the means of guidance (24) of the first connector (4);
- a second connection means (27) situated at a first end (28) of the second connector (5) for receiving the electromagnetic wave originating from the means of guidance (24) of the second connector (5) and making it circulate toward processing means (29);
the support device (2) being **characterized in that** it comprises a sample holder (1) as claimed in one of claims 1 to 9 disposed in a removable manner between the first and second connectors (4, 5).

11. The support device (2) as claimed in claim 10, **characterized in that** the first and second connectors (4, 5) each exhibit shoulders (30) where the sample holder (1) is housed and positioned.

12. The support device (2) as claimed in one of claims 10 or 11, **characterized in that** it comprises third means of clamping (31) of the first connector (4) on the second connector (5), away from the sample holder (1).
